# EUROPÄISCHE PATENTSCHRIFT

(11) **EP 1 335 995 B1**
(45) Veröffentlichungstag und Bekanntmachung des Hinweises auf die Patenterteilung: **29.09.2004**
(21) Anmeldenummer: 01980044.0
(22) Anmeldetag: 07.11.2001
(51) Int. Cl.: C23C 14/34, B22F 7/06

(54) **VERFAHREN ZUR HERSTELLUNG EINER VERDAMPFUNGSQUELLE**
METHOD FOR PRODUCING AN EVAPORATION SOURCE
PROCEDE DE FABRICATION D'UNE SOURCE D'EVAPORATION

(30) Priorität: 20.11.2000 AT 8512000
(43) Veröffentlichungstag der Anmeldung: 20.08.2003
(73) Patentinhaber: PLANSEE Aktiengesellschaft, 6600 Reutte, Tirol (AT)
(72) Erfinder: WILHARTITZ, Peter, A-6600 Reutte/Tirol (AT); SCHÖNAUER, Stefan, A-6600 Flach (AT); POLCIK, Peter, A-6600 Reutte/Tirol (AT)
(74) Vertreter: Lohnert, Wolfgang, Dr.
(86) Internationale Anmeldenummer: PCT/AT2001/000349
(87) Internationale Veröffentlichungsnummer: WO 2002/040735

(56) Entgegenhaltungen:
- US-A- 5 656 216
- US-A- 5 863 398
- US-A- 5 963 778
- PATENT ABSTRACTS OF JAPAN vol. 012, no. 434 (M-764), 16. November 1988 (1988-11-16) & JP 63 169307 A (TOKYO TUNGSTEN CO LTD), 13. Juli 1988 (1988-07-13)

## Beschreibung

Die Erfindung betrifft ein Verfahren zur Herstellung einer Verdampfungsquelle für die physikalische Dampfabscheidung, bestehend aus einem Target das neben einer oder mehreren weiteren Komponenten eine Aluminium-Komponente enthält und einer mit dem Target verbundenen Rückplatte aus einem Werkstoff besserer thermischer Leitfähigkeit als das Target, wobei das Target durch Kaltpressen einer Mischung der pulverförmigen Einzelkomponenten und anschließendes Umformen bei Temperaturen unterhalb der Schmelzpunkte der Einzelkomponenten unter Fließen bis zum Erreichen einer Dichte von mindestens 98 % der theoretischen Dichte hergestellt wird.

Sputter Targets für die physikalische Dampfabscheidung werden heute in großem Umfang zur Herstellung unterschiedlicher Schichten eingesetzt. Die Anwendung reicht von der Herstellung von verschleißfesten und korrosionsfesten Beschichtungen für die unterschiedlichsten Substratmaterialien, bis hin zur Herstellung geschichteter Materialverbunde insbesondere in der Halbleiter- und Elektronikindustrie.
Aufgrund dieses breiten Anwendungsspektrums müssen die verschiedenartigsten Beschichtungsmaterialien abgeschieden werden.

Problematisch ist es, wenn unterschiedliche Materialien gleichzeitig aufgestäubt werden sollen, die bei einer Legierungsbildung auf konventionelle Weise spröde intermetallische Phasen bilden würden, so dass sich derartige Legierungen praktisch nicht mehr kalt oder warm umformen und auch nur mit großem Aufwand spanabhebend verarbeiten lassen. Die Herstellung von Sputter Targets aus diesen Legierungen ist deshalb sehr schwierig oder sogar unmöglich.

Beispielsweise gehören Legierungen aus Aluminium und Titan zu diesen problematischen Werkstoffen und können auf vorteilhafte Weise nur mit dem eingangs erwähnten Verfahren zu Sputter Targets verarbeitet werden.

Dieses Verfahren ist ausführlich in der AT PS 388 752 beschrieben.

Sputter Targets werden generell in der Sputteranlage mechanisch auf wassergekühlten Kupferauflagen befestigt um die Oberflächentemperatur abzusenken. In den meisten Fällen liegt dabei das vollständig aus dem zu zerstäubenden Material gefertigte Sputter Target unmittelbar auf der Kupferauflage auf.

Da möglichst viel Material mit einem Sputter Target abgestäubt werden soll, wird angestrebt, die Sputter Targets mit einer möglichst großen Bauhöhe herzustellen. Dabei ist jedoch zu beachten, dass der mit der Vergrößerung der Bauhöhe zunehmende thermische Widerstand der Sputter Targets nicht zu groß wird, so dass die Oberflächentemperatur der Sputter Targets auf zulässigen Werten gehalten werden kann.
Da der Großteil der abzustäubenden Werkstoffe entweder eine verhältnismäßig gute thermische Leitfähigkeit aufweisen und/oder eine relativ hohe Oberflächentemperatur aufweisen können, ohne dass es zu Problemen kommt, sind die herkömmlichen Sputteranlagen auf relativ große Bauhöhen der Sputter Targets abgestimmt, wobei dann in diesen Anlagen Sputter Targets mit geringeren Bauhöhen nur mit starken Nachteilen eingesetzt werden können.
Insbesondere Aluminium mit einer hervorragenden thermischen Leitfähigkeit wird sehr häufig für Beschichtungsanwendungen mit Sputter-Technik eingesetzt, so dass viele Sputteranlagen, insbesondere auch von der Bauhöhe der Sputter Targets her auf die gute thermische Leitfähigkeit des Aluminiums abgestimmt sind.
Problematisch wird es dann in diesen Beschichtungsanlagen, wenn Aluminium zusammen mit Materialien abgestäubt werden soll, die eine relativ schlechte Wärmeleitfähigkeit aufweisen und die gleichzeitig beim Sputtervorgang nicht zu große Oberflächentemperaturen aufweisen dürfen, um beispielsweise unerwünschte Reaktionen zwischen mehreren Komponenten der Sputter Targets zu verhindern. So wird Aluminium vielfach zusammen mit Titan und gegebenenfalls zusätzlichen Komponenten für Beschichtungsanwendungen vor allem im Verschleißschutz eingesetzt.

Bei Sputter Targets aus diesen Werkstoffen verschlechtern bereits geringe Anteile an Titan die gute Wärmeleitfähigkeit des Aluminiums beträchtlich. Dadurch kann es bei diesen Sputter Targets, wenn sie in mit den üblicherweise für Sputteranlagen vorgesehenen Bauhöhen hergestellt werden bei hohen Beschichtungsraten zu so hohen Oberflächentemperaturen kommen, dass eine exotherme Reaktion eintritt, die zu einer Zerstörung des Targets führt.

Aber auch andere Werkstoffe die zusammen mit Aluminium mittels Sputter Targets abgestäubt werden, können kritisch sein und Probleme beim Beschichtungsvorgang bereiten. Für elektronische Anwendungen können beispielsweise Werkstoffkombinationen aus Aluminium mit Ta, Nd oder Y zum Einsatz kommen, während für optische und magnetische Speichermedien vielfach Werkstoffkombinationen aus Aluminium mit Ni und Cr eingesetzt werden.
Auch in Anwendungen Richtung Verschleißschutz, wo eine Werkstoffkomponente als Trockenschmierstoff wirkt, gehen beispielsweise Werkstoffkombinationen aus Aluminium mit Sn, Zn, Ag, W, Mo, vielfach auch in Verbindung mit zusätzlichen Ti-Anteilen.

Damit bei all diesen kritischen Werkstoffkombinationen die genannten Probleme bei der Beschichtung möglichst vermieden werden, ist man derzeit gezwungen die Abdampfgeschwindigkeit zu beschränken, um die Oberflächentemperatur nicht zu hoch ansteigen zu lassen.
Eine Möglichkeit die Oberflächentemperatur derart kritischer Sputter Targets auch bei hohen Beschichtungsraten herabzusetzen ohne die Bauhöhe zu verändem ist es, den Teil der Sputter Targets im Bereich der Kontaktzone mit der wassergekühlten Kupferauflage mit einer Rückplatte aus gut wärmeleitendem Material zu versehen und dann diese Rückplatte mechanisch mit der Kupferauflage zu verbinden.
Verfahren zur Herstellung derartiger Verdampfungsquellen, bei denen die Rückplatte durch Löten oder Diffusionsbonden mit dem Sputter Target verbunden wird, sind beispielsweise in der WO 00/22185 oder in der US 5 397 050 beschrieben.

Nachteilig bei derartig hergestellten Verdampfungsquellen ist, dass zwischen Target und Rückplatte eine Übergangszone schlechter thermischer Leitfähigkeit entstehen kann, die die Wärmeabfuhr von der Oberfläche des Sputter Targets in die Rückplatte und dann weiter in die gekühlte Kupferauflage nicht optimal gewährleistet.

Da schon eine um einige Grade höhere Temperatur an der Oberfläche des Sputter Targets Nachteile hinsichtlich der Abstäubungseigenschaften ergibt, sollten derartige Übergangszonen mit schlechter thermischer Leitfähigkeit nach Möglichkeit vermieden werden.

Aufgabe der vorliegenden Erfindung ist es daher, ein Verfahren zur Herstellung einer Verdampfungsquelle für die physikalische Dampfabscheidung zu schaffen, bei der das Sputter Target, welches Aluminiumanteile enthält ohne die Ausbildung einer Übergangszone schlechter thermischer Leitfähigkeit mit der Rückplatte verbunden wird.

Erfindungsgemäß wird dies dadurch erreicht, dass die Rückplatte ebenfalls aus pulverförmigem Ausgangsmaterial gemeinsam mit den Target-Komponenten in übereinander geschichteten Pulverfraktionen verpresst und anschließend umgeformt wird.

Auf diese Art und Weise lässt sich ein hervorragender Verbund zwischen Target Material und Rückplatte herstellen, ohne dass es zur Ausbildung einer Übergangszone mit schlechter thermischer Leitfähigkeit kommt, so dass eine hervorragende Temperaturabfuhr von der Oberfläche des Sputter Targets in die Rückplatte und dann in die wassergekühlte Kupferauflage erreicht wird.
Da die Sputter Targets mit der wassergekühlten Auflage in der Regel verschraubt oder geklemmt werden ist es sinnvoll, den Abschnitt des Targets der damit ohnehin nicht mehr abgesputtert werden kann, als Rückplatte auszuführen, so dass bei gleicher Bauhöhe im Vergleich zu Sputter Targets ohne Rückplatte gleich viel effektiv abdampfbares Material zur Verfügung steht.

Um eine besonders gute Verbindung des Target Materials mit der Rückplatte zu erreichen, sollte das Target vorteilhafterweise aus mindestens 15 Atom% Aluminium bestehen.

Sputter Targets bei denen sich die Erfindung in besonders vorteilhafter Weise verwirklichen lässt, sind Targets aus 15 Atom% Aluminium und 85 Atom% Titan.

Als besonders vorteilhafter Werkstoff für die Rückplatte der Verdampfungsquelle eignet sich reines Aluminium, das eine hervorragende thermische Leitfähigkeit aufweist. Da Aluminium verhältnismäßig weich ist, lässt sich durch die mechanische Verbindung mit der wassergekühlten Kupferauflage eine gute Übergangszone mit geringem thermischem Widerstand erreichen. Zudem ist der Schaden für die aufgestäubte Schicht nicht allzu groß, wenn versehentlich ein Durchsputtem über das Targetmaterial hinaus erfolgt und dadurch ein gewisser Anteil der Rückplatte mit aufgesputtert wird.
Neben Aluminium sind für die Rückplatte aber auch andere Materialien mit guter thermischer Leitfähigkeit, wie beispielsweise Kupfer, geeignet.

Eine bewährte Methode um beim Umformen des Presslings ein Fließen des Materials zu erreichen ist die Anwendung des Schmiedeverfahrens in Schmiedepressen.

Wird das Target aus Aluminium-Titan gefertigt, beispielsweise 15 Atom% Aluminium und 85 Atom% Titan, hat es sich bewährt, das Schmiedeverfahren bei einer Temperatur zwischen 400°C und 450°C durchzuführen.

Strangpressen ist eine andere Methode das Umformen des Presslings unter Fließen des Materials möglichst vorteilhaft durchzuführen.
Der Vorteil dieser Variante des erfindungsgemäßen Herstellungsverfahrens liegt darin, dass vom gepressten Strang, Sputter Targets mit unterschiedlichen Bauhöhen abgetrennt werden können.

Im folgenden wird die Erfindung anhand von Herstellungsbeispielen näher erläutert.

### BEISPIEL 1

Eine scheibenförmige Verdampfungsquelle mit einem Durchmesser von 63 mm und einer Gesamthöhe von 32 mm, bestehend aus einem 20 mm hohen Sputter Target aus 50 Atom% Aluminium und 50 Atom% Titan und einer mit dem Sputter Target fest verbundenen 12 mm hohen Rückplatte aus Aluminium wurde wie folgt nach dem erfindungsgemäßen Verfahren hergestellt.
Das Aluminiumpulver und Titanpulver für das Sputter Target mit einer durchschnittlichen Korngröße von 30 µm wurden in einem Taumelmischer vermischt.

In einer zweigeteilten Pressmatrize einer hydraulischen Presse, die in Hinsicht auf die Endabmessungen der Verdampfungsquelle ausreichendes Übermaß aufwies, wurde der Unterteil der Pressmatrize zunächst mit reinem Aluminiumpulver mit 30 µm mittlerer Korngröße befüllt und die Pulverfüllung glatt gestrichen. Dann wurde der Oberteil der Pressmatrize aufgesetzt und mit dem vermischten Aluminium-Titan-Pulver befüllt, die Pulvermischung wiederum glatt gestrichen und die Matrizenfüllung zu einem Grünling mit 94 % seiner theoretischen Dichte kaltverpresst.
Der Pressling wurde in einer Schmiedepresse mit halboffenem Gesenk mit einer Gesenktemperatur von etwa 200°C in insgesamt fünf Durchgängen unter Fließen bzw. Verkneten der einzelnen Komponenten nachverdichtet.
Der Pressling wurde dazu vor dem Nachverdichten und zwischen den einzelnen Verdichtungsschritten in einem Vorwärmofen auf eine Temperatur zwischen 400°C und 450°C gebracht. Durch die kurzen Umformzeiten und niedrigen Umformungstemperaturen war kein Oxidationsschutz erforderlich, so dass die Nachverdichtung in ungekanntem Zustand erfolgen konnte.
Abschließend wurde die Verdampfungsquelle durch mechanische Bearbeitung auf die Endabmessungen gebracht.
Von der Übergangszone zwischen dem Material des Sputter Targets und dem Material der Rückplatte wurde eine Gefügeaufnahme hergestellt.

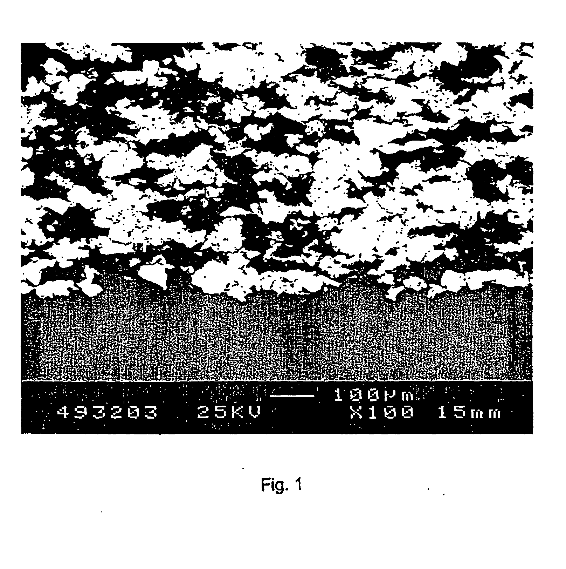

Figur 1 zeigt diese Übergangszone in 100-facher Vergrößerung.

Es ist deutlich der absolut homogene Übergang zwischen dem Material des Sputter Targets und dem Material der Rückplatte ohne die Ausbildung einer störenden Zwischenschicht mit verminderter thermischer Leitfähigkeit erkennbar.

### BEISPIEL 2

Für Vergleichszwecke wurde eine scheibenförmige Verdampfungsquelle mit gleichen Abmessungen wie im Beispiel 1 hergestellt. Zum Unterschied von Beispiel 1 besteht die Verdampfungsquelle vollständig aus einem Sputter Target aus 50 Atom% Aluminium und 50 Atom% Titan und enthält keine Rückplatte aus Aluminium. Die Herstellung des Sputter Targets erfolgte mit denselben Herstellungsparametem wie in Beispiel 1.

### BEISPIEL 3

Für Vergleichszwecke wurde eine Verdampfungsquelle bestehend aus einem Sputter Target und einer Rückplatte mit gleichen Abmessungen und gleichem Materialkombinationen wie in Beispiel 1 hergestellt. Zum Unterschied von Beispiel 1 wurde die Verdampfungsquelle nicht durch gleichzeitiges Verarbeiten der pulverförmigen Ausgangsmaterialien hergestellt. Vielmehr wurde die Rückplatte in den gleichen Abmessungen unabhängig vom Sputter Target aus einem schmelzmetallurgisch hergestelltem Kupferhalbzeug herausgearbeitet und dann unter Verwendung einer Indium-Zwischenschicht durch Bonden mit dem fertigen, pulvermetallurgisch hergestellten Sputter Target, das mit denselben Herstellungsparametern wie in Beispiel 1 hergestellt wurde, verbunden.

Die Verdampfungsquellen entsprechend den Beispielen 1 und 3 wurden nacheinander in einer ARC-Verdampfungsanlage eingebaut. und unter den gleichen üblicherweise angewandten Beschichtungsbedingungen ,mit einer ARC-Stromstärke von 60 A, was einem Wärmestrom von 0,7 MW/m² entspricht, abgesputtert und dabei die Oberflächentemperaturen der einzelnen Sputter Targets bestimmt.
Dabei ergaben sich nach einer Absputterzeit von etwa 2 Minuten, die folgenden Oberflächentemperaturen:
Die erfindungsgemäße, nach Beispiel 1 hergestellte Verdampfungsquelle wies eine Oberflächentemperatur von 315°C auf.
Das nach Beispiel 2 ohne Rückplatte hergestellte Sputter Target wies die höchste Oberflächentemperatur von 420°C auf.

Die nach Beispiel 3 hergestellte Verdampfungsquelle mit gebondeter Rückplatte wies eine Oberflächentemperatur von 395°C auf.
Die gegenüber dem Beispiel 1 deutlich höhere Oberflächentemperatur trotz Verwendung einer Rückplatte mit gleichen Abmessungen zeigt deutlich die äußerst nachteilige Auswirkung der für das Bonden notwendigen Indium-Zwischenschicht mit verminderter thermischer Leitfähigkeit auf.

Da schon eine um wenige Grade verminderte Oberflächentemperatur des Sputter Targets Vorteile in den Abstäubungseigenschaften mit sich bringt, ist der enorme Vorteil der erfindungsgemäßen Verdampfungsquelle gegenüber bisher entsprechend dem Stand der Technik vorgesehenen Verdampfungsquellen belegt.

## Patentansprüche

1. Verfahren zur Herstellung einer Verdampfungsquelle für die physikalische Dampfabscheidung, bestehend aus einem Target das neben einer oder mehreren weiteren Komponenten eine Aluminiumkomponente enthält und einer mit dem Target verbundenen Rückplatte aus einem Werkstoff besserer thermischer Leitfähigkeit als das Target, wobei das Target durch Kaltpressen einer Mischung der pulverförmigen Einzelkomponenten und anschließendes Umformen bei Temperaturen unterhalb der Schmelzpunkte der Einzelkomponenten unter Fließen bis zum Erreichen einer Dichte von mindestens 98 % der theoretischen Dichte hergestellt wird,
**dadurch gekennzeichnet,**
**dass** die Rückplatte ebenfalls aus pulverförmigem Ausgangsmaterial gemeinsam mit den Targetkomponenten in übereinander geschichteten Pulverfraktionen verpresst und anschließend umgeformt wird.

2. Verfahren zur Herstellung einer Verdampfungsquelle für die physikalische Dampfabscheidung nach Anspruch 1, **dadurch gekennzeichnet, dass** das Target aus mindestens 15 Atom% Aluminium besteht.

3. Verfahren zur Herstellung einer Verdampfungsquelle für die physikalische Dampfabscheidung nach Anspruch 2, **dadurch gekennzeichnet, dass** das Target als Zweitkomponente 85 Atom% Titan enthält.

4. Verfahren zur Herstellung einer Verdampfungsquelle für die physikalische Dampfabscheidung nach einem der Ansprüche 1 bis 3, **dadurch gekennzeichnet, dass** als Werkstoff für die Rückplatte Aluminium verwendet wird.

5. Verfahren zur Herstellung einer Verdampfungsquelle für die physikalische Dampfabscheidung nach einem der Ansprüche 1 bis 4, **dadurch gekennzeichnet, dass** das Umformen durch Schmieden in Schmiedepressen erfolgt.

6. Verfahren zur Herstellung einer Verdampfungsquelle für die physikalische Dampfabscheidung nach Anspruch 3, **dadurch gekennzeichnet, dass** das Umformen durch Schmieden in Schmiedepressen bei einer Temperatur zwischen 400°C und 450°C erfolgt.

7. Verfahren zur Herstellung einer Verdampfungsquelle für die physikalische Dampfabscheidung nach einem der Ansprüche 1 bis 4, **dadurch gekennzeichnet, dass** das Umformen durch Strangpressen erfolgt.

8. Verfahren zur Herstellung einer Verdampfungsquelle für die physikalische Dampfabscheidung nach Anspruch 3, **dadurch gekennzeichnet, dass** das Umformen durch Strangpressen bei einer Temperatur zwischen 400°C und 450°C erfolgt.

## Claims

1. A process for producing an evaporation source for physical vapour deposition, consisting of a target, which besides one or more further components includes an aluminium component, and also of a backing plate connected to the target and made of a material having better thermal conductivity than the target, the target being produced by cold pressing of a mixture of the pulverulent individual components and by subsequent forming at temperatures below the melting-points of the individual components, subject to flow, until a density of at least 98% of the theoretical density is attained, **characterised in that**
the backing plate is likewise press-moulded from pulverulent raw material jointly with the target components in powder fractions stratified above one another and is subsequently formed.

2. Process for producing an evaporation source for physical vapour deposition according to Claim 1, **characterised in that** the target consists of at least 15 atomic percent aluminium.

3. Process for producing an evaporation source for physical vapour deposition according to Claim 2, **characterised in that** the target contains 85 atomic percent titanium by way of secondary component.

4. Process for producing an evaporation source for physical vapour deposition according to one of Claims 1 to 3, **characterised in that** aluminium is used as material for the backing plate.

5. Process for producing an evaporation source for physical vapour deposition according to one of Claims 1 to 4, **characterised in that** forming is effected by forging in forging presses.

6. Process for producing an evaporation source for physical vapour deposition according to Claim 3, **characterised in that** forming is effected by forging in forging presses at a temperature between 400 °C and 450 °C.

7. Process for producing an evaporation source for physical vapour deposition according to one of Claims 1 to 4, **characterised in that** forming is effected by extrusion moulding.

8. Process for producing an evaporation source for physical vapour deposition according to Claim 3, **characterised in that** forming is effected by extrusion moulding at a temperature between 400 °C and 450 °C.

## Revendications

1. Procédé de fabrication d'une source d'évaporation pour dépôt physique en phase vapeur, qui se compose d'une cible qui contient, en plus d'un ou plusieurs composants additionnels, un composant en aluminium et une plaque arrière assemblée à la cible en matière à meilleure conductivité thermique que celle de la eible, dans lequel la cible est fabriquée par compression à froid d'un mélange des composants individuels en poudre, suivie d'une déformation par fluage à des températures inférieures aux points de fusion des composants individuels jusqu'à ce qu'une densité d'au moins 98% de la densité théorique soit atteinte,
**caractérisé en ce que**
la plaque arrière dont la matière de départ consiste aussi en poudre est comprimée en commun avec les composants de cible, dans des fractions de poudres superposées les unes aux autres, et ensuite déformée en commun avec eux.

2. Procédé de fabrication d'une source d'évaporation pour dépôt physique en phase vapeur selon la revendication 1, **caractérisé en ce que** la teneur atomique en aluminium dans la cible est d'au moins 15%.

3. Procédé de fabrication d'une source d'évaporation pour dépôt physique en phase vapeur selon la revendication 2, **caractérisé en ce que** la cible contient comme deuxième composant du titane à une teneur atomique de 85%.

4. Procédé de fabrication d'une source d'évaporation pour dépôt physique en phase vapeur selon l'une quelconque des revendications précédentes, **caractérisé en ce que** de l'aluminium est utilisé comme matière pour la plaque arrière.

5. Procédé de fabrication d'une source d'évaporation pour dépôt physique en phase vapeur selon l'une quelconque des revendications précédentes, **caractérisé en ce que** la déformation s'effectue par forgeage dans des presses de forgeage.

6. Procédé de fabrication d'une source d'évaporation pour dépôt physique en phase vapeur selon la revendication 3, **caractérisé en ce que** la déformation s'effectue par forgeage dans des presses de forgeage à une température comprise entre 400°C et 450°C.

7. Procédé de fabrication d'une source d'évaporation pour dépôt physique en phase vapeur selon l'une quelconque des revendications 1 à 4, **caractérisé en ce que** la déformation s'effectue par extrusion.

8. Procédé de fabrication d'une source d'évaporation pour dépôt physique en phase vapeur selon la revendication 3, **caractérisé en ce que** la déformation s'effectue par extrusion à une température comprise entre 400°C et 450°C.
